# EUROPÄISCHE PATENTSCHRIFT

(11) **EP 1 148 514 B1**
(45) Veröffentlichungstag und Bekanntmachung des Hinweises auf die Patenterteilung: **21.06.2006**
(21) Anmeldenummer: 01108879.6
(22) Anmeldetag: 09.04.2001
(51) Int. Cl.: G11C 11/22, G11C 7/06

(54) **Schaltungsanordnung zum Auslesen einer Speicherzelle mit einem ferroelektrischen Kondensator**
Read circuit for a memory cell having a ferroelectrical capacitor
Circuit de lecture pour cellule de mémoire ayant un condensateur ferroélectrique

(30) Priorität: 19.04.2000 DE 10019481
(43) Veröffentlichungstag der Anmeldung: 24.10.2001
(73) Patentinhaber: Infineon Technologies AG, 81669 München (DE)
(72) Erfinder: Braun, Georg, 80339 München (DE); Hönigschmid, Heinz, East Fishkill, NY 12524 (US)
(74) Vertreter: Epping - Hermann - Fischer

(56) Entgegenhaltungen:
- US-A- 5 544 114
- US-A- 5 905 671
- US-A- 5 999 439
- US-A- 6 094 394

## Beschreibung

Die vorliegende Erfindung betrifft eine Schaltungsanordnung zum Auslesen einer Speicherzelle, die einen ferroelektrischen Kondensator aufweist.

Speicherzellen mit ferroelektrischen Kondensatoren sind beispielsweise aus den Patentschriften US 5,986,919; US 5,969,980; US 5,991,188 und US 6,002,634 bekannt. Eine ferroelektrische Speicherzelle umfaßt dabei einen ferroelektrischen Kondensator und einen Auswahltransistor, die ähnlich einem herkömmlichen Kondensator und einem Auswahltransistor in einer DRAM (Dynamic Random Access Memory)-Speicherzelle angeordnet sind. Eine Patentschrift, die sich speziell mit einem Leseverstärker (Sense Amplifier) für ferroelektrische Speicherzellen befaßt, ist US 5,999,439. Dort wird als Leseverstärker ein Flip-Flop mit zwei Eingängen an zwei benachbarte Bitleitungen angeschlossen.

Üblicherweise sind ferroelektrische Speicherzellen so aufgebaut, daß eine Elektrode des ferroelektrischen Kondensators mit einer Spannungsquelle und die andere Elektrode mit dem Auswahltransistor verbunden ist. Der Auswahltransistor ist mit seinem Gate an eine Wortleitung und mit einem Source-Drain-Gebiet, das dem ferroelektrischen Kondensator abgewandt ist, an eine Bitleitung angeschlossen.

Die Informationsspeicherung in einem ferroelektrischen Speicher wird in der Polarisation des ferroelektrischen Materials durchgeführt. Dabei repräsentiert die "Remanenz" des ferroelektrischen Kondensators die gespeicherte Information.

Um die ferroelektrische Speicherzelle auszulesen, wird der Auswahltransistor mit einer geeigneten Gate-Spannung geöffnet, so daß der ferroelektrische Kondensator niederohmig mit der Bitleitung verbunden ist. Anschließend wird die Spannung der an dem ferroelektrischen Kondensator anliegenden Spannungsquelle variiert, so daß ein Lesesignal auf der Bitleitung entsteht. Die Bitleitung weist aufgrund ihrer geometrischen Anordnung in dem ferroelektrischen Speicher eine Bitleitungskapazität auf, die zusammen mit dem ferroelektrischen Kondensator einen kapazitiven Spannungsteiler bildet und so die zur Verfügung stehende Spannung auf eine Spannung, die über der Bitleitung und eine Spannung, die über dem ferroelektrischen Kondensator abfällt, aufteilt.

Die Spannung, die an der Bitleitungskapazität abfällt, sollte möglichst groß sein, da dann ein nachgeschalteter Leseverstärker ein großes Eingangssignal erhält und den Zustand der ferroelektrischen Speicherzelle sicher bewerten kann.

Allerdings gilt, je größer die Spannung wird, die an der Bitleitungskapazität abfällt, desto kleiner ist die Spannung, die an dem ferroelektrischen Kondensator abfällt. Dies wird problematisch, wenn die an dem ferroelektrischen Kondensator abfallende Spannung nicht mehr die Koerzitivspannung erreicht. In diesem Fall ist eine eindeutige Unterscheidung zwischen der oberen und der unteren Hysteresekurve des Ferroelektrikums nicht mehr möglich, da die umgeladene Ladungsmenge bzw. die "Umpolarisation" des ferroelektrischen Kondensators nicht mehr vollständig erreicht wird und somit unterhalb der Bewertungsschwelle des nachgeschalteten Leseverstärkers liegt.

Diese beiden gegenläufigen Dimensionierungsbedingungen für die Kapazität des ferroelektrischen Kondensators und die Kapazität der Bitleitung beschränken die Dimensionierungsfreiheit und Realisierbarkeit von ferroelektrischen Speichern und Speicherfeldern sehr stark.

Aus den beiden gegenläufigen Bedingungen folgt, daß es für die Bitleitungskapazität im Verhältnis zu der Kapazität des ferroelektrischen Kondensators einen optimalen Wert gibt. Ergibt sich für eine gegebene Kapazität des ferroelektrischen Kondensators eine sehr große Bitleitungskapazität, so wird die Bitleitung sehr lang ausgebildet, was zu einer großen Zeitkonstante der Bitleitung führt. Dadurch ist die ferroelektrische Speicherzelle und der ferroelektrische Speicher bezüglich der Lesegeschwindigkeit stark verlangsamt. Folgt aus einer gegebenen Kapazität des ferroelektrischen Kondensators, daß eine sehr kleine Bitleitungskapazität verwendet werden sollte, so ist die Bitleitung sehr kurz zu wählen, wodurch eine Zellenfeldarchitektur mit sehr vielen Bitleitungen und Leseverstärkern benötigt wird. Dies führt zu einem großen Platzbedarf des ferroelektrischen Speichers.

Um eine optimale Flächenausnutzung im ferroelektrischen Speicherzellenfeld zu erreichen, muß also von dem optimalen Verhältnis zwischen Bitleitungskapazität zu der Kapazität des ferroelektrischen Kondensators abgewichen werden. Dies führt aus den oben genannten Gründen zu einer Reduktion des Lesesignals auf der Bitleitung.

Es ist die Aufgabe der Erfindung, eine Schaltungsanordnung zum Auslesen einer Speicherzelle mit ferroelektrischem Kondensator anzugeben, mit der das Verhältnis von Bitleitungskapazität zu der Kapazität des ferroelektrischen Kondensators in einem größeren Bereich gewählt werden kann.

Erfindungsgemäß wird die Aufgabe gelöst durch eine Schaltungsanordnung gemäß Anspruch 1.

US-A-5 905 671 beschreibt einen ferroelektrischen Speicher gemäss des Oberbegriffs des Anspruchs 1.

In IT-B-1 298 939 (=US-A-6 094 394) ist bei einem EPROM Speicher vorgesehen, den Ausgang des Sense Amplifiers (6) über eine Treiberschaltung (M6) auf die Bitleitung (MATSIDE) rückzukoppeln. Dadurch wird beim Auslesen die Bitleitung schneller als bei bekannten Schaltungen wieder auf das Referenzpotential (REFSIDE) angehoben und dadurch die Recoveryzeit der Bitleitung verringert (fig.4c im Vergleich zu figs.4a,b).

Die erfindungsgemäße Lösung der Aufgabe führt ein neues Bewertungsprinzip für ferroelektrische Speicher ein. Ein Gedanke dabei ist, daß die Spannung der Bitleitung beim Auslesen der ferroelektrischen Speicherzelle durch einen Regelkreis auf den Wert eines Referenzsignals geregelt wird. Beim Auslesen der ferroelektrischen Speicherzelle bleibt somit die Spannung der Bitleitung annähernd, bis auf eine Regelabweichung, konstant. Die Spannung der an dem ferroelektrischen Kondensator angeschlossen Spannungsquelle wird variiert. Dadurch wird die über dem ferroelektrischen Kondensator abfallende Spannung im wesentlichen durch die Spannung der Spannungsquelle bestimmt und ist unabhängig von dem Verhältnis zwischen Bitleitungskapazität und der Kapazität des ferroelektrischen Kondensators. Die erste Treiberschaltung dient dazu, den Regelkreis zu schließen und die Rückkopplung von dem Differenzverstärkerausgang zu dem ersten Differenzverstärkereingang zu bewerkstelligen. Da bei ferroelektrischen Speichern und ferroelektrischen Kondensatoren die Ladungsmenge, die zum Umpolarisieren des ferroelektrischen Kondensators benötigt wird, die zu messende Größe darstellt, ist die erste Treiberschaltung vorzugsweise so ausgebildet, daß sie in Abhängigkeit des Eingangssignals an dem ersten Treibereingang dem ferroelektrischen Kondensator eine entsprechende Ladungsmenge an dem ersten Treiberausgang bereitstellt und damit die Spannung der Bitleitung weitestgehend konstant hält.

Weiterhin kann vorgesehen werden, daß eine zweite Treiberschaltung mit einem zweiten Treibereingang und einem zweiten Treiberausgang angeordnet wird und der Differenzverstärkerausgang mit dem zweiten Treibereingang verbunden ist. Die zweite Treiberschaltung arbeitet beispielsweise äquivalent zu der ersten Treiberschaltung. Allerdings dient sie dazu, eine ihr nachgeschaltete Schaltungsanordnung, mit Ladung zu versorgen. Durch die zweite Treiberschaltung ist es in vorteilhafter Weise möglich, eine nachfolgende Schaltung mit der gleichen, mit einer proportionalen oder mit einer äquivalenten Ladungsmenge, wie den ferroelektrischen Kondensator zu versorgen.

Eine weitere Ausgestaltung der Erfindung ist, daß eine Bewerterschaltung mit einem Bewertereingang und einem Bewerterausgang vorgesehen ist und der Bewertereingang mit dem zweiten Treiberausgang verbunden ist. Die der zweiten Treiberschaltung nachgeschaltete Bewerterschaltung hat die Aufgabe, das von der zweiten Treiberschaltung gelieferte Ladungssignal zu bewerten und für nachfolgende Schaltungsteile in eine angemessene Form zu transformieren, die z.B. CMOS-kompatible Spannungspegel aufweist.

Gemäß einer weiteren Ausführung der Erfindung wird die Bitleitung mit dem Differenzverstärker und der ersten Treiberschaltung auf die Spannung des Referenzsignals geregelt. Dadurch, daß die Bitleitung auf den Wert des Referenzsignals geregelt wird, bleibt die Spannung auf der Bitleitung annähernd konstant. Dies führt in vorteilhafter Weise dazu, daß die Bitleitung nicht auf einen anderen Spannungswert umgeladen werden muß, wodurch die ferroelektrische Speicheranordnung schnell ausgelesen werden kann. Weiterhin ist vorteilhaft, daß die an dem ferroelektrischen Kondensator abfallende Spannung im wesentlichen von der Spannungsquelle bestimmt wird. Dadurch ist die an dem ferroelektrischen Kondensator abfallende Spannung weder von der Bitleitungskapazität noch von der Polarisation des Ferroelektrikums in dem ferroelektrischen Kondensator abhängig.

Eine Weiterbildung der Erfindung sieht vor, daß die ferroelektrische Speicherzelle einen ferroelektrischen Kondensator und einen Auswahltransistor mit einem Gate-Anschluß aufweist, wobei ein erster Anschluß des ferroelektrischen Kondensators mit einer Spannungsquelle und ein zweiter Anschluß des ferroelektrischen Kondensators mit einem Source-Gebiet des Auswahltransistors und die Bitleitung mit einem Drain-Gebiet des Auswahltransistors verbunden ist. Die beschriebene ferroelektrische Speicherzelle eignet sich besonders gut, um mit der erfindungsgemäßen Schaltungsanordnung ausgelesen zu werden. Die beschriebene ferroelektrische Speicherzelle ist kompakt und besteht lediglich aus zwei Bauelementen.

Die erfindungsgemäße Anordnung sieht darüber hinaus vor, daß der Bewerter einen Komparator mit einem ersten Komparatoreingang und einem zweiten Komparatoreingang aufweist, wobei der erste Komparatoreingang mit einem Referenzsignal und der zweite Komparatoreingang mit einem Meßkondensator und mit dem zweiten Treiberausgang verbunden ist. Der Meßkondensator hat die Aufgabe, die von der zweiten Treiberschaltung gelieferte Ladungsmenge zu summieren und sich auf einen entsprechenden Spannungspegel aufzuladen, welcher der Polarisation der ferroelektrischen Speicherzellen äquivalent ist. Durch die Größe des Meßkondensators kann der Spannungshub eingestellt werden, der von der Ladungsmenge erzeugt wird, die von der zweiten Treiberschaltung geliefert wird.

Der nachgeschaltete Komparator vergleicht die an dem Meßkondensator anliegende Spannung mit einer Referenzspannung und erzeugt an seinem Ausgang eine Spannung, die einer logischen "1" oder einen logischen "0" entspricht. Die Referenzspannung wird so gewählt, daß die an dem Meßkondensator anliegende Spannung im Falle eines nicht umpolarisierten ferroelektrischen Kondensators und im Falle eines umpolarisierten ferroelektrischen Kondensators einmal unterhalb und einmal oberhalb der Referenzspannung liegt.

Die erfindungsgemäße Schaltungsanordnung zum Auslesen einer ferroelektrischen Speicherzelle trennt den Schritt des Auslesens der Zellinformation und den Schritt der Bewertung der Zellinformation. Dadurch lassen sich diese beiden Aufgaben unabhängig voneinander optimieren.

Weitere Ausgestaltungen der Erfindung sind in den Unteransprüchen angegeben.

Die Erfindung wird nachfolgend an einem Ausführungsbeispiel anhand von Figuren näher erläutert.

In den Figuren zeigen:
- Figur 1: eine ferroelektrische Speicherzelle;
- Figur 2: eine erfindungsgemäße Schaltungsanordnung zum Auslesen einer Speicherzelle mit ferroelektrischem Kondensator;
- Figur 3: die erfindungsgemäße Ausgestaltung einer Bewerterschaltung.

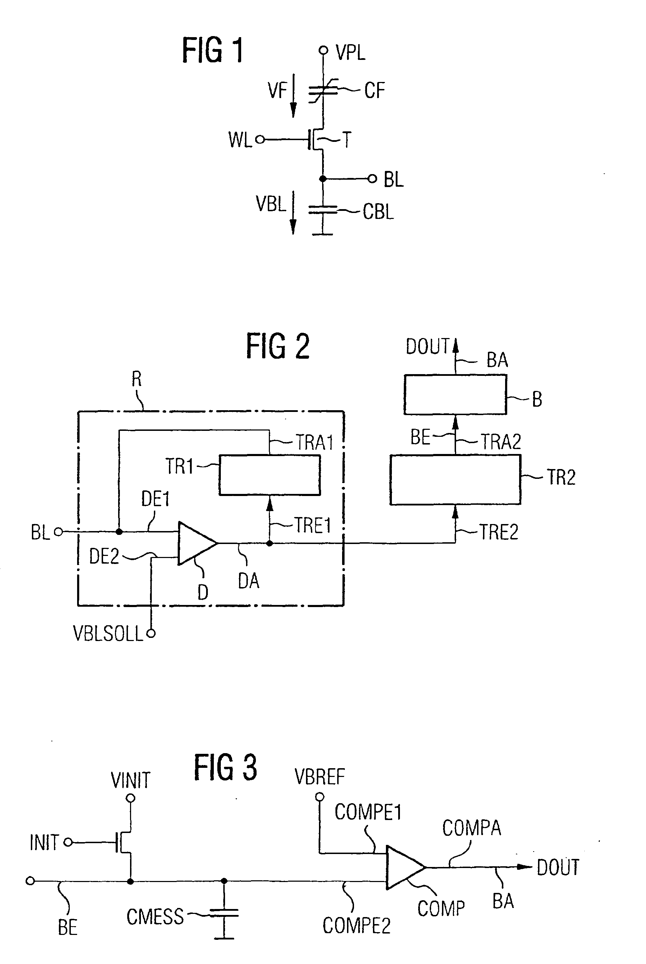

In Figur 1 ist eine ferroelektrische Speicherzelle FSPZ mit einem ferroelektrischen Kondensator CF dargestellt. Der ferroelektrische Kondensator CF ist zum einen an eine Spannungsquelle VPL angeschlossen und zum anderen an einen Auswahltransistor T, der über einen Gate-Anschluß WL gesteuert wird und seinerseits an eine Bitleitung BL angeschlossen ist. Aufgrund der geometrischen Ausgestaltungen der Bitleitung BL weist die Bitleitung BL eine parasitäre Bitleitungskapazität CBL auf. Wird bei geöffnetem Transistor T eine Spannung mit der Spannungsquelle VPL an die ferroelektrische Speicherzelle FSPZ angelegt, so fällt über dem ferroelektrischen Kondensator CF die Spannung VF und über der Bitleitungskapazität CBL die Spannung VBL ab. Die Anordnung aus ferroelektrischem Kondensator CF und Bitleitungskapazität CBL wirkt als kapazitiver Spannungsteiler. Zum Auslesen der ferroelektrischen Speicherzelle FSPZ wird üblicherweise der Auswahltransistor T mit einer geeigneten Spannung an seinem Gate-Anschluß WL geöffnet, so daß der ferroelektrische Kondensator CF niederohmig mit der Bitleitung BL verbunden ist. Üblicherweise wird anschließend die Spannung der Spannungsquelle VPL variiert und ein Lesesignal auf der Bitleitung BL erzeugt.

In Figur 2 ist eine erfindungsgemäße Schaltungsanordnung zum Auslesen einer ferroelektrischen Speicherzelle gezeigt. Die Schaltungsanordnung beinhaltet dabei einen Differenzverstärker D, der einen ersten Differenzverstärkereingang DE1 und einen zweiten Differenzverstärkereingang DE2 aufweist. Der erste Differenzverstärkereingang DE1 ist beispielsweise invertierend und der zweite Differenzverstärkereingang DE2 ist beispielsweise nicht invertierend. Der zweite Differenzverstärkereingang DE2 ist mit einem Referenzsignal VBLSOLL verbunden, der erste Differenzverstärkereingang DE1 ist mit der Bitleitung BL verbunden. Üblicherweise weist ein Differenzverstärker einen positiven und einen negativen Eingang auf. In diesem Ausführungsbeispiel ist der zweite Differenzverstärkereingang DE2 der positive Eingang und der erste Differenzverstärkereingang DE1 der negative Eingang.

Weiterhin ist eine erste Treiberschaltung TR1 mit einem ersten Treiberausgang TRA1 und einem ersten Treibereingang TRE1 so angeordnet, daß der Differenzverstärkerausgang DA mit dem ersten Treibereingang TRE1 und der erste Treiberausgang TRA1 mit der Bitleitung BL verbunden ist. Die beschriebene Anordnung entspricht folglich einem rückgekoppelten Differenzverstärker. Die rückgekoppelte Schaltung ist mit einer gestrichelten Linie umrahmt und wird als Regelkreis R bezeichnet. Die erste Treiberschaltung TR1 dient in diesem Ausführungsbeispiel dazu, die Bitleitung BL mit einer Ladungsmenge zu versorgen, die von dem Signal des Differenzverstärkerausgangs DA bestimmt wird. Diese Ladung dient dazu, die Bitleitungsspannung VBL auf den Referenzwert des Referenzsignals VBLSOLL zu regeln.

Weiterhin ist eine zweite Treiberschaltung TR2 mit einem zweiten Treibereingang TRE2 und einem zweiten Treiberausgang TRA2 so angeordnet, daß der Differenzverstärkerausgang DA mit dem zweiten Treibereingang TRE2 verbunden ist.

Eine Bewerterschaltung B, die einen Bewertereingang BE und einen Bewerterausgang BA aufweist, ist so angeordnet, daß der zweite Treiberausgang TRA2 mit dem Bewertereingang BE verbunden ist. Die zweite Treiberschaltung TR2 hat hierbei die Aufgabe, die Bewerterschaltung B mit einer Ladungsmenge zu versorgen, die der Ladungsmenge äquivalent ist, mit der die Bitleitung BL über die erste Treiberschaltung TR1 versorgt wurde. Durch diese Schaltungsanordnung wird erreicht, daß die Bewerterschaltung B mit einer Ladungsmenge versorgt wird, die gleich oder proportional oder äquivalent der Ladungsmenge ist, die über die Bitleitung BL dazu diente, den ferroelektrischen Kondensator CF der ferroelektrischen Speicherzelle FSPZ auszulesen. Der Bewerterausgang BA dient dabei als Datenausgang DOUT der erfindungsgemäßen Schaltungsanordnung.

In Figur 3 ist eine weitere Ausgestaltung der erfindungsgemäßen Bewerterschaltung dargestellt. Die Bewerterschaltung umfaßt einen Komparator COMP mit einem ersten Komparatoreingang COMPE1 und einem zweiten Komparatoreingang COMPE2 und einem Komparatorausgang COMPA. Der erste Komparatoreingang COMPE1 ist mit einer Referenzspannung VBREF verbunden. Der zweite Komparatoreingang COMPE2 ist mit dem Bewertereingang BE und mit einem Meßkondensator CMESS verbunden. Die dem zweiten Komparatoreingang COMPE2 abgewandte Elektrode des Meßkondensator ist mit einem Bezugspotential verbunden. Der Komparatorausgang COMPA ist mit dem Ausgang der Bewerterschaltung BA und damit mit dem Datenausgang DOUT verbunden. Der Meßkondensator CMESS dient dazu, die Ladungsmenge auf zu summieren, die über den Bewertereingang BE der Bewerterschaltung B zugeführt wird. Dabei lädt sich der Messkondensator CMESS auf einen entsprechenden Spannungspegel auf. Der an dem Meßkondensator CMESS anliegende Spannungspegel wird mit der Referenzspannung VBREF mittels des Komparators COMP verglichen und ein entsprechendes Ausgangssignal DOUT erzeugt. Um die Bewerterschaltung B zum Anfang einer Bewertung in einen definierten Zustand zu versetzen dient ein Transistor, der mit dem Bewertereingang BE und mit einer Initialisierungsspannungsquelle VINIT verbunden ist und über ein Initialisierungssignal INIT gesteuert wird.

### Bezugszeichenliste

- B: Bewerterschaltung
- BA: Bewerterausgang
- BE: Bewertereingang
- BL: Bitleitung
- CF: ferroelektrischer Kondensator
- COMP: Komparator
- COMPA: Komparatorausgang
- COMPE1: erster Komparatoreingang
- COMPE2: zweiter Komparatoreingang
- CMESS: Meßkondensator
- D: Differenzverstärker
- DA: Differenzverstärkerausgang
- DE1: erster Differenzverstärkereingang
- DE2: zweiter Differenzverstärkereingang
- DOUT: Ausgangssignal
- INIT: Initialisierungssignal
- FSPZ: ferroelektrische Speicherzelle
- R: Regelkreis
- T: Auswahltransistor
- TR1: erste Treiberschaltung
- TR2: zweite Treiberschaltung
- TRA1: erster Treiberausgang
- TRA2: zweiter Treiberausgang
- TRE1: erster Treibereingang
- TRE2: zweiter Treibereingang
- VBREF: Referenzspannung
- VBLSOLL: Referenzsignal
- VPL: Spannungsquelle
- VF: Spannung über dem ferroelektrischen Kondensator
- VPL: Spannung über der Bitleitungskapazität
- VINIT: Initialisierungsspannung
- WL: Gate-Anschluß

## Patentansprüche

1. Schaltungsanordnung zum Auslesen einer Speicherzelle mit einem ferroelektrischen Kondensator, umfassend
- eine Bitleitung (BL), die mit der Speicherzelle verbunden ist;
- einen Differenzverstärker (D), der einen ersten Differenzverstärkereingang (DE1) und einen zweiten Differenzverstärkereingang (DE2) und einen Differenzverstärkerausgang (DA) aufweist; - wobei der erste Differenzverstärkereingang (DE1) invertierend und der zweite Differenzverstärkereingang (DE2) nicht invertierend ist; - wobei der erste Differenzverstärkereingang (DE1) mit der Bitleitung (BL) und der zweite Differenzverstärkereingang (DE2) mit einem Referenzsignal (VBLSOLL) verbunden ist;
**dadurch gekennzeichnet, daß**
- eine erste Treiberschaltung (TR1) mit einem ersten reiz bereingang (TRE1) und einem ersten Treiberausgang (TRA1) vorgesehen ist,
- wobei der Differenzverstärkerausgang (DA) mit dem ersten Treibereingang (TRE1) und der erste Treiberausgang (TRA1) mit der Bitleitung (BL) verbunden ist, und wobei während des Auslesens der Speicherzelle mit dem ferroelektrischen Kondensator das Potential der Bitleitung (BL) von dem Differenzverstärker (D) auf das Potential des Referenzsignals (VBLSOLL) geregelt wird.

2. Anordnung nach Anspruch 1,
**dadurch gekennzeichnet, daß**
eine zweite Treiberschaltung (TR2) mit einem zweiten Treibereingang (TRE2) und einem zweiten Treiberausgang (TRA2) vorgesehen ist und der Differenzverstärkerausgang (DA) mit dem zweiten Treibereingang (TRE2) verbunden ist.

3. Anordnung nach einem der Ansprüche 1 oder 2,
**dadurch gekennzeichnet, daß**
eine Bewerterschaltung (B) mit einem Bewertereingang (BE) und einem Bewerterausgang (BA) vorgesehen ist und der Bewertereingang (BE) mit dem zweiten Treiberausgang (TRA2) verbunden ist.

4. Anordnung nach einem der Ansprüche 1 bis 3,
**dadurch gekennzeichnet, daß**
die Bitleitung (BL) mit dem Differenzverstärker (D) und der ersten Treiberschaltung (TR1) auf die Spannung des Referenzsignals (VBLSOLL) geregelt wird.

5. Anordnung nach einem der Ansprüche 1 bis 4,
**dadurch gekennzeichnet, daß**
die ferroelektrische Speicherzelle (FSPZ) einen ferroelektrischen Kondensator (CF) und einen Auswahltransistor (T) mit einem Gate-Anschluß (WL) aufweist, wobei ein erster Anschluß des ferroelektrischen Kondensators (CF) mit einer Spannungsquelle (VPL) und ein zweiter Anschluß des ferroelektrischen Kondensators (CF) mit einem Source-Gebiet des Auswahltransistors (T) und die Bitleitung (BL) mit einem Drain-Gebiet des Auswahltransistors (T) verbunden ist.

6. Anordnung nach einem der Ansprüche 1 bis 5,
**dadurch gekennzeichnet, daß**
der Bewerter (B) einen Komparator (COMP) mit einem ersten Komparatoreingang (COMPE1) und einem zweiten Komparatoreingang (COMPE2) aufweist, wobei der erste Komparatoreingang (COMPE1) mit einer Referenzspannung (VBREF) und der zweite Komparatoreingang (COMPE2) mit einem Meßkondensator (CMESS) und mit dem zweiten Treiberausgang (TRA2) verbünden ist.

## Claims

1. Circuit arrangement for reading a memory cell having a ferroelectric capacitor, comprising
- a bit line (BL) which is connected to the memory cell;
- a differential amplifier (D) which has a first differential amplifier input (DE1), a second differential amplifier input (DE2) and a differential amplifier output (DA);
- with the first differential amplifier input (DE1) being inverting and the second differential amplifier input (DE2) being non-inverting;
- with the first differential amplifier input (DE1) being connected to the bit line (BL), and the second differential amplifier input (DE2) being connected to a reference signal (VBLSOLL);
**characterized in that**
- a first driver circuit (TR1) is provided having a first driver input (TRE1) and a first driver output (TRA1),
- with the differential amplifier output (DA) being connected to the first driver input (TRE1), and the first driver output (TRA1) being connected to the bit line (BL), and during the reading of the memory cell having the ferroelectric capacitor the potential on the bit line (BL) being regulated at the potential of the reference signal (VBLSOLL) by the differential amplifier (D).

2. Arrangement according to Claim 1,
**characterized in that**
a second driver circuit (TR2) is provided having a second driver input (TRE2) and a second driver output (TRA2), and the differential amplifier output (DA) is connected to the second driver input (TRE2).

3. Arrangement according to one of Claims 1 or 2,
**characterized in that**
an assessment circuit (B) is provided having an assessment input (BE) and an assessment output (BA), and the assessment input (BE) is connected to the second driver output (TRA2).

4. Arrangement according to one of Claims 1 to 3,
**characterized in that**
the bit line (BL) together with the differential amplifier (D) and the first driver circuit (TR1) are regulated at the voltage of the reference signal (VBLSOLL).

5. Arrangement according to one of Claims 1 to 4,
**characterized in that**
the ferroelectric memory cell (FSPZ) has a ferroelectric capacitor (CF) and a selection transistor (T) with a gate connection (WL), with a first connection of the ferroelectric capacitor (CF) being connected to a voltage source (VPL), and a second connection of the ferroelectric capacitor (CF) being connected to a source region of the selection transistor (T), and the bit line (BL) being connected to a drain region of the selection transistor (T).

6. Arrangement according to one of Claims 1 to 5,
**characterized in that**
the assessment device (B) has a comparator (COMP) having a first comparator input (COMPE1) and a second comparator input (COMPE2), with the first comparator input (COMPE1) being connected to a reference voltage (VBREF), and the second comparator input (COMPE2) being connected to a measurement capacitor (CMESS) and to the second driver output (TRA2).

## Revendications

1. Circuit de lecture d'une cellule de mémoire ayant un condensateur ferroélectrique, comprenant
- une ligne (BL) de bits, qui est reliée à la cellule de mémoire ;
- un amplificateur (D) différentiel qui a une première entrée (DE1) d'amplificateur différentiel et une deuxième entrée (DE2) d'amplificateur différentiel et une sortie (DA) d'amplificateur différentiel ;
- dans lequel la première entrée (DE1) d'amplificateur différentiel est inverseuse et la deuxième entrée (DE2) d'amplificateur différentiel n'est pas inverseuse ;
- dans lequel la première entrée (DE1) d'amplificateur différentiel est reliée à la ligne (BL) de bits et la deuxième entrée (DE2) d'amplificateur différentiel est reliée à un signal (VBLSOLL) de référence ;
**caractérisé en ce que**
- il est prévu un premier circuit (TR1) d'attaque ayant une première entrée (TRE1) d'attaque et une première sortie (TRA1) d'attaque ;
- dans lequel la sortie (DA) de l'amplificateur différentiel est reliée à la première entrée (TRE1) d'attaque et la première sortie (TRA1) d'attaque est reliée à la ligne (BL) de bits, et
dans lequel pendant la lecture de la cellule de mémoire ayant le condensateur ferroélectrique, le potentiel de la ligne (BL) de bits est réglé par l'amplificateur (D) différentiel sur le potentiel du signal (VBLSOLL) de référence.

2. Circuit suivant la revendication 1,
**caractérisé en ce qu'**il est prévu un deuxième circuit (TR2) d'attaque ayant une deuxième entrée (TRE2) d'attaque et une deuxième sortie (TRA2) d'attaque, et la sortie (DA) de l'amplificateur différentiel est reliée à la deuxième entrée (TRE2) d'attaque.

3. Circuit suivant l'une des revendications 1 ou 2,
**caractérisé en ce qu'**il est prévu un circuit (B) d'évaluation ayant une entrée (BE) d'évaluation et une sortie (BA) d'évaluation et l'entrée (BE) d'évaluation est reliée à la deuxième sortie (TRA2) d'attaque.

4. Circuit suivant l'une des revendications 1 à 3,
**caractérisé en ce que** la ligne (BL) de bits ayant l'amplificateur (D) différentiel et le premier circuit (TR1) d'attaque est réglée à la tension du signal (VBLSOLL) de référence.

5. Circuit suivant l'une des revendications 1 à 4,
**caractérisé en ce que** la cellule (FSPZ) de mémoire ferroélectrique a un condensateur (CF) ferroélectrique et un transistor (T) de sélection ayant une borne (WL) de grille, une première borne de condensateur (CF) ferroélectrique étant reliée à une première source (VPL) de tension et une deuxième borne de condensateur (CF) ferroélectrique étant reliée à une zone de source du transistor (T) de sélection, et la ligne (BL) de bits étant reliée à une zone de drain du transistor (T) de sélection.

6. Circuit suivant l'une des revendications 1 à 5,
**caractérisé en ce que** l'évaluation (B) comprend un comparateur (COMP) ayant une première entrée (COMPE1) de comparateur et une deuxième entrée (COMPE2) de comparateur, une tension (VBREF) de référence étant appliquée à la première entrée (COMPE1) de comparateur et la deuxième entrée (COMPE2) de comparateur étant reliée à un condensateur (CMESS) de mesure et à la deuxième sortie (TRA2) d'attaque.
